# EUROPEAN PATENT SPECIFICATION

(11) **EP 1 579 488 B1**
(45) Date of publication and mention of the grant of the patent: **07.12.2011**
(21) Application number: 03813688.3
(22) Date of filing: 15.12.2003
(51) Int. Cl.: H01L 21/28, H01L 21/336, H01L 21/285

(54) **METHOD OF MANUFACTURING A SEMICONDUCTOR DEVICE**
VERFAHREN ZUR HERSTELLUNG EINES HALBLEITERBAUELEMENTS
PROCEDE DE FABRICATION D'UN DISPOSITIF SEMI-CONDUCTEUR

(30) Priority: 20.12.2002 EP 02080508
(43) Date of publication of application: 28.09.2005
(73) Proprietor: NXP B.V., 5656 AG Eindhoven (NL); IMEC, 3001 Leuven (BE)
(72) Inventor: VENEZIA, Vincent, C., NL-5656 AA Eindhoven (NL); DACHS, Charles, J., J., NL-5656 AA Eindhoven (NL); HOOKER, Jacob, C., NL-5656 AA Eindhoven (NL); VAN DAL, Marcus, J., H., NL-5656 AA Eindhoven (NL)
(74) Representative: Williamson, Paul Lewis
(86) International application number: PCT/IB2003/006009
(87) International publication number: WO 2004/057659

(56) References cited:
- US-A- 5 449 937
- US-A1- 2001 003 056
- US-B1- 6 211 000
- US-B1- 6 284 612
- US-B1- 6 348 390
- US-B1- 6 365 468
- MASZARA W P ET AL: "Transistors with dual work function metal gates by single full silicidation (FUSI) of polysilicon gates" INTERNATIONAL ELECTRON DEVICES MEETING 2002. IEDM. TECHNICAL DIGEST. SAN FRANCISCO, CA, DEC. 8 - 11, 2002, NEW YORK, NY: IEEE, US, 8 December 2002 (2002-12-08), pages 367-370, XP010626061 ISBN: 0-7803-7462-2

## Description

The invention relates to a method of manufacturing a semiconductor device with a field effect transistor, in which method a semiconductor body of a semiconductor material is provided, at a surface thereof, with a source region and a drain region and with a gate region between the source region and the drain region, which gate region comprises a semiconductor region of a further semiconductor material that is separated from the surface of the semiconductor body by a gate dielectric, and with spacers adjacent to the gate region for forming the source and drain regions, in which method the source region and the drain region are provided with a metal layer which is used to form a compound of the metal and the semiconductor material, and the drain region is provided with a further metal layer which is used to form a compound of the metal and the further semiconductor material. The MOSFET (= Metal Oxide Semiconductor Field Effect Transistor) with a polysilicon gate obtained by this method may suffer from the problem that a depletion layer effect therein may result in an - unwanted - reduction of the effective gate capacitance of the MOSFET and the transistor drive current. This effect has become a significant limitation in CMOS (= Complementary MOS) downscaling. Increasing the doping at the gate-gate dielectric interface can reduce said depletion layer, however gate doping is limited by the solubility of dopants in poly-silicon. Therefore alternatives to poly-silicon - or amorphous silicon or monocrystalline silicon - gates have to be found.

A method as mentioned in the opening paragraph is known from US patent 6,204,103, which was issued on March 20, 2001. Therein such a method is described in column 6 line 51 to column 7 line 10, in which the source and the drain of a silicon MOSFET are silicided with one metal layer and the gate is silicided with another metal layer, the latter metal layer being different for the polysilicon gates of a NMOS and a PMOS transistor. This procedure offers the possibility of avoiding the above-mentioned depletion effect and thus reduction of the effective gate capacitance may be avoided.

A drawback of such a method is that it is rather complicated as it comprises different steps for siliciding source and drain on the one hand and a polysilicon gate on the other hand. Moreover, it contains several other steps like a CMP (= Chemical Mechanical Polishing) step, which increase the complexity of the method.

US 6348390 describes a method for fabricating MOSFETs with a recessed self-aligned silicide contact and extended source/drain junctions is described. A gate structure having a gate insulating layer, a first conductive layer and a first dielectric layer is formed on a substrate. A thermal oxide layer is formed on the substrate and on sidewalls of the first conductive layer. Sidewall spacers are formed on sidewalls of the gate structure. The thermal oxide layer uncovered by the sidewall spacers is removed. The substrate is isotropically etched to form recessed regions on the substrate in regions uncovered by the gate structure and the sidewall spacers. A first metal layer is formed on the substrate after the first dielectric layer is removed. A source/drain/gate implantation is performed to the substrate, thereby forming source/drain regions under the recessed regions.

US 2001003056 describes that after a cobalt film is deposited on a silicon-containing film formed on a semiconductor substrate, a first heat treatment at a relatively low temperature is performed with respect to the semiconductor substrate to cause a reaction between the cobalt film and the silicon layer and thereby form a Co2Si layer or CoSi layer in at least a surface portion of the silicon layer. Then, a silicon-containing film is deposited on the Co2Si layer or CoSi layer and a second heat treatment at a relatively high temperature is performed with respect to the semiconductor substrate to cause a reaction between the silicon-containing film and the Co2Si layer or CoSi layer and thereby form a CoSi2 layer in at least a surface portion of the silicon layer.

The invention is defined in the accompanying claims.

An embodiment of the invention can avoid the above drawbacks and to provide a method which is simple and offers the possibility of avoiding the above mentioned depletion layer effect, in particular in MOSFETs with a polysilicon gate.

In accordance with an embodiment of the invention, spacers are formed, a sacrificial region of a material that may be selectively etched with respect to the semiconductor region is deposited on top of the semiconductor region, and after the spacers have been formed, the sacrificial layer is removed by etching, and after removal of the sacrificial layer, a single metal layer is deposited contracting the source, drain and gale regions. The invention is based, inter alia, on the recognition that full silicidation of a polysilicon gate, by which the above-mentioned depletion layer effect is avoided, is possible. Moreover this may be carried out at the same time as the silicidation of the source and the drain, provided that the thickness of the polysilicon gate is limited to a thickness which is relatively small, compared to the standard gate thickness of current processes. The invention is further based on the recognition that a reduction of said thickness is unwanted as the height of a gate stack would decrease, which has large impacts on the technology used, such as on ion implant energies and spacer thickness. By providing a sacrificial region on the semiconductor region of a gate stack, the height of the gate stack may be kept constant while the layer thickness of the semiconductor region is reduced. The thickness of the sacrificial region is chosen to be complimentary to the desired reduction of the semiconductor region. Thus the above impacts on technology are avoided and at the same time the method according to the invention is relatively simple as merely a single metal layer is needed for siliciding both the source and drain regions and the gate region. The total height chosen for the gate stack depends on the technology in question, i.e. on the size of the actual transistor. As an example, for a standard CMOS process the standard semiconductor region may be e.g. 100 nm thick. In that case the semiconductor region may be reduced to e.g. 50 nm while the sacrificial region is chosen to be also 50 nm.

The sacrificial region may be easily removed before deposition of the metal layer due to the fact that it can be etched selectively relative to e.g the polysilicon. In this way the height and width of the spacers remain unaffected as they are determined by the total height of the total gate stack. The etching of the sacrificial region may be either wet or dry.

In summary advantages of a method according to an embodiment of the invention include that only slight changes to a standard CMOS process are required, i.e. addition of difficult steps like photolithography and CMP are not required, that it results in a fully silicide gate and thus that no depletion effect occurs during operation of the device. Moreover, the device obtained remains - after removal of the spacers - relatively planar, which makes the deposition, patterning and etching of a subsequent pre-metal dielectric layer much easier.

In one embodiment, the spacers can be formed by depositing a layer of a dielectric material on top of the semiconductor body on which the gate region comprising the semiconductor region and the sacrificial region is present and by subsequently removing the deposited layer on top of and on both sides of the gate region by etching. This process is simple and width and height of the spacers depend on the height of the gate stack and the thickness of the dielectric layer deposited.

From the above it is clear that the best results with respect to reduction of the depletion layer effect are obtained if the semiconductor region, e.g. the polysilicon, is completely consumed during the formation of the compound of the metal and the further semiconductor material.

In one embodiment, the formation of the compounds between the metal and the semiconductor material and the metal and the further semiconductor material is carried out in two separate heating steps, the first heating step resulting in an intermediate compound with a lower content of the semiconductor material or the further semiconductor material and in the second heating step the intermediate compound being converted to the compound having a higher content of the semiconductor material or of the further semiconductor material. Thus, in case of a silicon MOST and a Cobalt metal layer, the intermediate compound will be e.g. CoSi while the compound will be CoSi₂. The sheet resistance of the latter material is considerably smaller than that of the former, which clearly is an important advantage. In one embodiment, a part of the metal layer which has not reacted to form the intermediate compound is removed by etching between the first and the second heating step.

In another modification, a layer of the further semiconductor material, i.e. a polysilicon layer in the case of a silicon MOST, is deposited on the surface of the semiconductor body between the two heating steps. During the second thermal treatment this layer, which is e.g. 5 to 10 nm thick, acts as a source of silicon for the formation of e.g. CoSi₂ from the CoSi. Therefore, the deposition of this layer relieves constraints on the thickness of the poly-silicon consumable gate, i.e. the semiconductor silicon region of the gate. The unreacted part of e.g. the polysilicon layer is removed after the second heating step. This may be done either by a selective dry or wet etch or by oxidation and subsequent removal of the resulting oxide by an etching agent based on HF.

The spacers can be removed after the formation of the compounds of the metal and the semiconductor material and of the metal and the further semiconductor material, In this way the resulting structure remains relatively planar. In general silicon is the preferred material for the semiconductor material and the further semiconductor material, while the intermediate compound and the compound are formed by silicides. Silicon is presently the most widely and most successfully used material within the semiconductor industry.

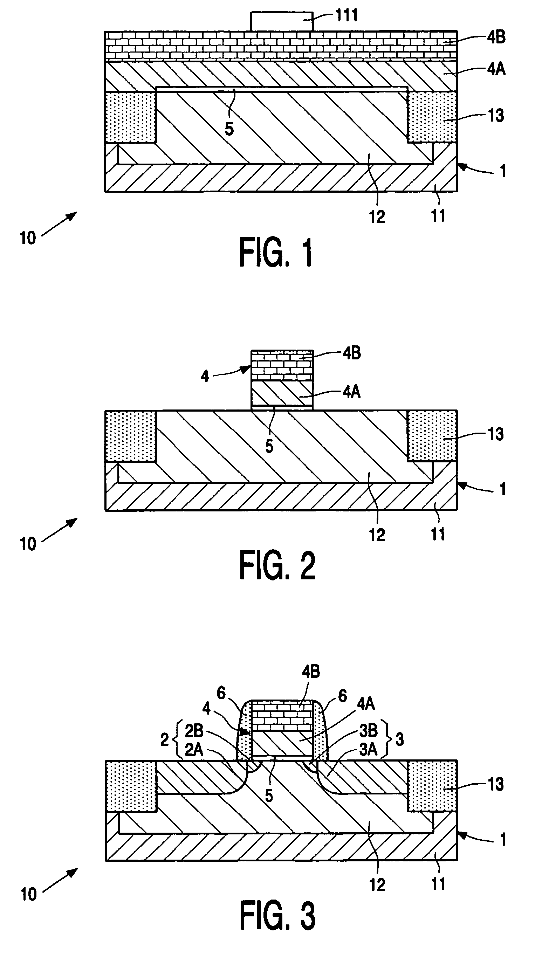

Figures 1 through 6 are sectional views of a semiconductor device at various stages in the manufacture of the device by means of a method in accordance with the invention. The device 10 (see Fig. 1) comprises a semiconductor body 1 which, in this case, is made of silicon but which may alternatively be made of another suitable semiconductor material. The basis for the body 1 is a p-type silicon substrate 11 in which an n-type so-called well 12 is formed. In the body 1 isolation regions 13 - so-called trenches - of silicon dioxide are formed. Subsequently on the surface of the silicon body 1 a gate oxide 5 is formed by thermal oxidation. Then a semiconductor layer 4A, here a polycrystalline silicon layer, is formed by CVD (= Chemical Vapor Deposition) on top of which a sacrificial layer 4B is deposited also by CVD, which sacrificial layer in this example is of silicon nitride, a material which may be selectively removed from the underlying polycrystalline silicon material 4A. A mask 111 is then formed on top of the stack at the location of the gate 4 to be formed.

Subsequently (see Fig. 2) both the silicon nitride layer 4B and the polycrystalline silicon layer 4A are removed outside the area of the mask 111, by which step a gate stack 4 is formed comprising gate oxide 5, polycrystalline region 4A and sacrificial region 4B. The thickness of the region 4A was chosen to be 40 nm and that of the sacrificial region 4B was chosen to be 60 nm. The thickness of the gate stack 4 thus is approximately equal to 100 nm, which in a standard CMOS process corresponds to the height for sub 100 nm devices.

Next (see Fig. 3) shallow n-type implantations 2B,3B are made to form the LDD (= Lightly Doped Drain) extensions of the source and drain regions 2,3 of the MOSFET to be formed. Next a high-energy p-type - so called HALO - tilted implantation is carried out, which is not separately shown in the drawing and which is performed to raise the channel doping at the LDD edge. Then spacers 6 are formed as follows. A dielectric layer 6 of silicon dioxide is deposited by means of CVD over the device 10. thus covering the gate stack 4. The thickness of the dielectric layer 6 in this example amounts to 90 - 100 nm. Then, by means of dry etching, the deposited layer is again removed such that the surface of the body 1 at both sides of the gate stack 4 as well as the upper surface of the sacrificial region 4B are clear. Due to the isotropic nature of the etching, spacers 6 of silicon dioxide remain attached to the side faces of the gate stack 4. Now deeper n+ type implantations 2A,3A are carried out in order to complete the source and drain 2,3 formation. The semiconductor body is then annealed at a temperature of 1000 to 1100 degree Celsius in order to activate the source and drain implantations 2A,2B,3A,3B. Fig. 3 shows all these steps in a single picture.

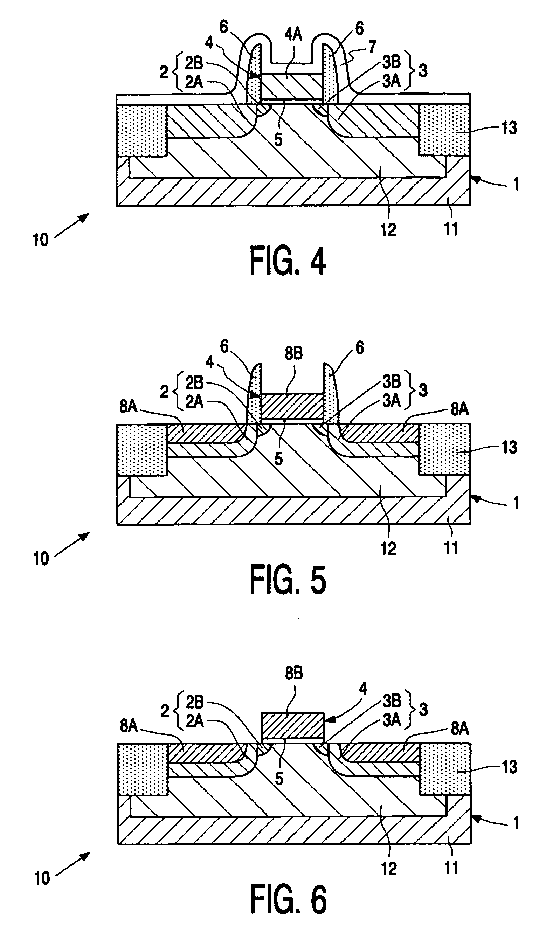

Subsequently (see Fig. 4) the sacrificial region 4B of the gate stack 4 is removed by selective etching. Etching is done in this example by means of wet etching using hot phosphoric acid as an etchant for the silicon nitride of region 4B In this way the etching is not only selective with respect to the polycrystalline region 4A but also with respect to the silicondioxide of the spacers 6 and a thin thermal oxide which may be present on the surface of the semiconductor body 1 on both sides of the gate stack 4. Next, a metal layer 7 is deposited over the structure 10. In this example the metal layer 7 comprises a 10 nm thick cobalt layer and a 8 nm thick titanium layer on top thereof. The function of the titanium layer may be to prevent shortcuts after the silicidation and to act as a barrier for and/or getter of oxygen.

Next (see Fig. 5) the device 10 is thermally treated in order to form silicided regions 8, i.e. region 8A from a part of the source and drain 2,3 and region 8B from the polycrystalline region 4A. In this example the formation of silicided regions 8A,8B take place by using two heating steps: a first one between 400 and 600°C, here at about 540 degrees Celsius, in which the cobalt layer 7 turns to CoSi. Next the unreacted titanium and the unreacted cobalt are removed by etching. Then a second heating step is performed between 600 and 900°C, here at about 850 degrees Celsius. In this step the CoSi formed in regions 8 is converted into CoSi₂. On the one hand, now the regions 8A have a suitable thickness and on the other hand the polycrystalline region 4A becomes fully silicided region 8B. Thus, a depletion layer effect in the gate 4 is avoided.

Finally (see Fig. 6) the spacers 6 are removed by dry etching. The resulting structure 10 now is (again) relatively planar although the height of the gate stack 4 in intermediate stages of the manufacture has been considerably larger than the resulting height of the gate 4. The manufacture of the MOSFET is further completed by deposition of a pre-metal dielectric, e.g. silicon dioxide, followed by patterning thereof, deposition of a contact metal layer, e.g. of aluminum, again followed by patterning. The latter steps are not shown in the Figure.

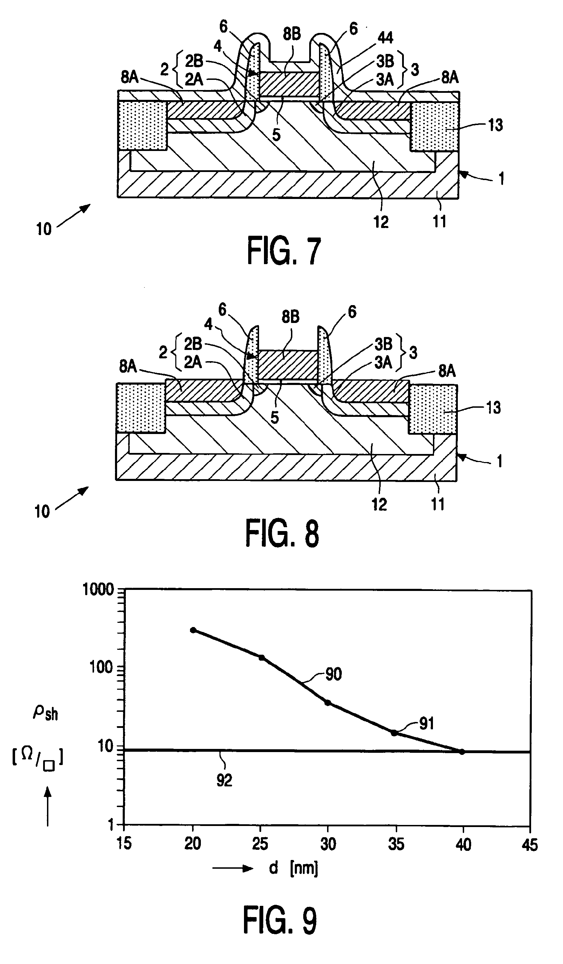

Figs 7 and 8 are sectional views of a semiconductor device at various stages in the manufacture of the device by means of a modification of the method in accordance with the invention. Most of the steps of the method correspond to those of the previous example, and for their description reference is made here to the above part of the description. The stages shown in Figures 7 and 8 correspond to the stage of Figure 5 in the previous example. After the first heating step (see Figure 7) in which the metal layer 7 has reacted with silicon, thereby forming silicide regions 8A,8B comprising CoSi, and after removal of the remaining titanium and cobalt not taking part in the reaction, a thin polycrystalline silicon layer 44 is deposited by means of CVD on top of the structure 10. The thickness of layer 44 may be in the range of 5 to 10 nm. Next (see Fig. 8) the second heating step is performed in which the CoSi is converted to CoSi₂. The silicon layer 44 will be at least partly consumed in this step and the remainder thereof is removed by an etching step. In this way the requirement of an accurate determination of the polycrystalline region 4A is mitigated. The importance of an accurate determination of the thickness of the polycrystalline region 4A in a method without the steps of the second example can be elucidated with reference to Fig. 9.

Fig 9 shows the sheet resistance as a function of the thickness of the polycrystalline region of the gate of a device manufactured by a method in accordance with the invention. Curve 90 which connects measuring points 91 shows the sheet resistance (ρₛₕ) of regions 8 found in these experiments as a function of the thickness (d) of the polycrystalline region 4A of the gate 4. Curve 92 corresponds to the sheet resistance of bulk CoSi₂, which is equal to about 8 ohm/square, the sheet resistance of CoSi being higher. Thus, it is clear that, in this example, the conditions of which correspond to those of the first embodiment described above, only for a thickness of the region 4A of about 40 nm, the desired full conversion to CoSi₂ is realized.

It will be obvious that the invention is not limited to the examples described herein, and that within the scope of the invention many variations and modifications are possible to those skilled in the art.

For example, instead of silicon nitride for the sacrificial region also other suitable materials or a combination of materials may be used such as silicon oxynitride or an alloy of silicon and germanium. The spacers could (then) be made of a material other than silicondioxide, e.g. silicon nitride. Furthermore, instead of a thermal oxide, a deposited oxide could be used to form the gate dielectric. In a favorable modification, the gate dielectric comprises silicon nitride, preferably deposited by CVD, as this material is more stable with respect to the siliciding process. It is further noted that to form a silicide other metals may be used instead of cobalt, like titanium or molybdenum. The silicidation could be done in a single step. The semiconductor body could be made of another semiconductor material such as GaAs or Germanium. In these cases still a polycrystalline or amorphous silicon gate could be used.

## Claims

1. A method of manufacturing a semiconductor device (10) with a field effect transistor, in which method a semiconductor body (1) of a semiconductor material is provided, at a surface thereof, with a source region (2) and a drain region (3) and with a gate region (4) between the source region (2) and the drain region (3), which gate region comprises a semiconductor region (4A) of a further semiconductor material that is separated from the surface of the semiconductor body (1) by a gate dielectric (5), and with spacers (6) adjacent to the gate region (4) for forming the source and drain regions (2, 3), the method comprising:
depositing a sacrificial region (4B) of a material on top of the semiconductor region (4A), wherein the sacrificial region (4B) is selectively etchable with respect to the semiconductor region (4A);
forming the spacers (6);
after the spacers (6) have been formed, removing the sacrificial layer (4B) by etching;
after removal of the sacrificial layer (4B), depositing a single metal layer (7) contacting the source, drain and gate regions (2, 3, 4);
forming a compound (8) of the metal and the semiconductor material of the semiconductor body (1); and
forming a compound (8) of the metal and the further semiconductor material of the semiconductor region (4A) of the gate region, wherein the semiconductor region (4A) is completely consumed during the formation of the compound (8).

2. A method as claimed in claim 1, wherein the spacers (6) are formed by depositing a layer of a dielectric material on top of the semiconductor body (1) on which the gate region (4) comprising the semiconductor region (4A) and the sacrificial region (4B) is present and by subsequently removing the deposited layer on top of and on both sides of the gate region (4) by etching.

3. A method as claimed in claim 1 or claim 2, wherein the formation of the compounds (8) between the metal and the semiconductor material and the metal and the further semiconductor material is carried out in two separate heating steps, the first heating step resulting in an intermediate compound with a low content of the semiconductor material or of the further semiconductor material and in the second heating step the intermediate compound being converted to the compound having a higher content of the semiconductor material or of the further semiconductor material.

4. A method as claimed in claim 3, wherein between the two heating steps, a part of the metal layer (7) which has not reacted to form the intermediate compound is removed by etching.

5. A method as claimed in claim 3 or 4, wherein between the two heating steps, a layer (44) of the further semiconductor material is deposited on the surface of the semiconductor body (1).

6. A method as claimed in claim 5, wherein after the second heating step, a part of the layer (44) of the further semiconductor material which has not reacted to form the compound is removed by etching.

7. A method as claimed in anyone of the preceding claims, wherein after the formation of the compounds of the metal and the semiconductor material and of the metal and the further semiconductor material, the spacers (6) are removed.

8. A method as claimed in anyone of the preceding claims, wherein for the semiconductor material as well as for the further semiconductor material silicon is chosen, and for the intermediate compound and for the compound of the metal and the semiconductor material and the further semiconductor material a metal silicide is chosen.

## Patentansprüche

1. Ein Verfahren zum Herstellen einer Halbleitervorrichtung (10) mit einem Feldeffekttransistor, in welchem Verfahren ein Halbleiterkörper (1) eines Halbleitermaterials, auf einer Oberfläche davon, mit einem Quellenbereich (2) und einem Ablaufbereich (3) und mit einem Gatebereich (4) zwischen dem Quellenbereich (2) und dem Ablaufbereich (3), welcher Gatebereich einen Halbleiterbereich (4A) aus einem weiteren Halbleitermaterial aufweist, welches von der Oberfläche des Halbleiterkörpers (1) mittels eines Gatedielektrikums (5) getrennt ist, und mit Abstandshaltern (6) neben dem Gatebereich (4) zum Formen der Quellen- und Ablaufbereiche (2, 3) bereitgestellt wird, das Verfahren aufweisend:
Abscheiden eines Opferbereichs (4B) aus einem Material oben auf dem Halbleiterbereich (4A), wobei der Opferbereich (4B) selektiv ätzbar bezüglich des Halbleiterbereichs (4A) ist;
Formen der Abstandshalter (6);
nach dem die Abstandshalter (6) geformt wurden, Entfernen der Opferschicht (4B) mittels Ätzens;
nach dem Entfernen der Opferschicht (4B), Abscheiden einer einzelnen Metallschicht (7), welche die Quellen-, Ablauf- und Gatebereiche (2, 3, 4) kontaktiert;
Formen eines Gemischs (8) des Metalls und des Halbleitermaterials des Halbleiterkörpers (1); und
Formen eines Gemischs (8) des Metalls und des weiteren Halbleitermaterials des Halbleiterbereichs (4A) des Gatebereichs, wobei der Halbleiterbereich (4A) vollständig während der Formation des Gemischs (8) aufgebraucht wird.

2. Verfahren gemäß Anspruch 1, wobei die Abstandshalter (6) mittels eines Abscheidens einer Schicht eines dielektrischen Materials oben auf dem Halbleiterkörper (1), auf welchem der Gatebereich (4) vorhanden ist, der den Halbleiterbereich (4A) und den Opferbereich (4B) aufweist, und mittels anschließenden Entfernens mittels Ätzens der abgeschiedenen Schicht oben auf und auf beiden Seiten des Gatebereichs (4) geformt werden.

3. Verfahren gemäß Anspruch 1 oder Anspruch 2, wobei die Formation des Gemisch (8) zwischen dem Metall und dem Halbleitermaterial und dem Metall und dem weiteren Halbleitermaterial in zwei getrennten Heizschritten durchgeführt wird, wobei der erste Heizschritt in einem Zwischenproduktgemisch mit einem geringen Gehalt des Halbleitermaterials oder des weiteren Haltleitermaterials resultiert und wobei in dem zweiten Heizschritt das Zwischenproduktgemisch zu einem Gemisch konvertiert wird, das eine höheren Gehalt des Halbleitermaterials oder des weiteren Halbleitermaterials hat.

4. Verfahren gemäß Anspruch 3, wobei zwischen den zwei Heizschritten ein Teil der Metallschicht (7), welche nicht eine Reaktion eingegangen ist, um das Zwischenproduktgemisch zu formen, mittels Ätzens entfernt wird.

5. Verfahren gemäß Anspruch 3 oder 4, wobei zwischen den zwei Heizschritten eine Schicht (44) des weiteren Halbleitermaterials auf der Oberfläche des Halbleiterkörpers (1) abgeschieden wird.

6. Verfahren gemäß Anspruch 5, wobei nach dem zweiten Heizschritt ein Teil der Schicht (44) des weiteren Halbleitermaterials, welches nicht eine Reaktion eingegangen ist, um das Gemisch zu formen, mittels Ätzens entfernt wird.

7. Verfahren gemäß irgendeinem der vorangehenden Ansprüche, wobei nach der Formation der Gemische des Metalls und des Halbleitermaterials und des Metalls und des weiteren Halbleitermaterials die Abstandshalter (6) entfernt werden.

8. Verfahren gemäß irgendeinem der vorangehenden Ansprüche, wobei für das Halbleitermaterial sowie für das weitere Halbleitermaterial Silizium gewählt wird und für das Zwischenproduktgemisch und für das Gemisch des Metalls und des Halbleitermaterials und des weiteren Halbleitermaterials ein Metallsilizid gewählt wird.

## Revendications

1. Procédé de fabrication d'un dispositif semi-conducteur (10) avec un transistor à effet de champ, dans lequel procédé est disposé un corps semi-conducteur (1) d'un matériau semi-conducteur à la surface de celui-ci, avec une région de source (2) et une région de drain (3) et avec une région de grille (4) entre la région de source (2) et la région de drain (3), laquelle région de grille comprend une région semi-conductrice (4A) d'un autre matériau semi-conducteur qui est séparée de la surface du corps semi-conducteur (1) par un diélectrique de grille (5), et avec des espaceurs (6) adjacents à la région de grille (5) pour former les régions de source et de drain (2, 3), le procédé comprenant :
le dépôt d'une région sacrificielle (4B) d'un matériau au-dessus de la région semi-conductrice (4A), dans lequel la région sacrificielle (4B) peut être gravée de manière sélective par rapport à la région semi-conductrice (4A) ;
la formation des espaceurs (6) ;
une fois que les espaceurs (6) ont été formés, l'enlèvement par gravure de la couche sacrificielle (4B) ;
après suppression de la couche sacrificielle (4B), le dépôt d'une couche de métal unique (7) faisant contact avec les régions de source, de drain et de grille (2, 3, 4) ;
la formation d'un composé (8) du métal et du matériau semi-conducteur du corps semi-conducteur (1) ; et
la formation d'un composé (8) du métal et de l'autre matériau semi-conducteur de la région semi-conductrice (4A) de la région de grille, dans lequel la région semi-conductrice (4A) est entièrement consommée pendant la formation du composé (8).

2. Procédé selon la revendication 1, dans lequel les espaceurs (6) sont formés par le dépôt d'une couche de matériau diélectrique au-dessus du corps semi-conducteur (1) sur lequel est présente la région de grille (4) comprenant la région semi-conductrice (4A) et la région sacrificielle (4B) et par l'élimination ultérieure, par gravure, de la couche déposée sur le dessus et sur les deux côtés de la région de grille (4).

3. Procédé selon la revendication 1 ou la revendication 2, dans lequel la formation des composés (8) entre le métal et le matériau semi-conducteur et entre le métal et l'autre matériau semi-conducteur est réalisée lors de deux étapes de chauffage séparées, la première étape de chauffage conduisant à un composé intermédiaire avec une faible teneur en matériau semi-conducteur ou en un autre matériau semi-conducteur, et le composé intermédiaire étant converti, dans la deuxième étape de chauffage, en un composé ayant une teneur plus élevée en matériau semi-conducteur ou en un autre matériau semi-conducteur.

4. Procédé selon la revendication 3, dans lequel entre les deux étapes de chauffage, une partie de la couche de métal (7) qui n'a pas réagi pour former le composé intermédiaire est éliminée par gravure.

5. Procédé selon les revendications 3 ou 4, dans lequel, entre les deux étapes de chauffage, une couche (44) de l'autre matériau semi-conducteur est déposée sur la surface du corps semi-conducteur (1).

6. Procédé selon la revendication 5, dans lequel après la deuxième étape de chauffage, une partie de la couche (44) de l'autre matériau semi-conducteur qui n'a pas réagi pour former le composé est éliminée par gravure.

7. Procédé selon l'une quelconque des revendications précédentes, dans lequel, après la formation des composés du métal et du matériau semi-conducteur et du métal et de l'autre matériau semi-conducteur, les espaceurs (6) sont éliminés.

8. Procédé selon l'une quelconque des revendications précédentes, dans lequel on choisit du silicium comme matériau semi-conducteur ainsi que comme autre matériau semi-conducteur, et dans lequel on choisit un siliciure métallique comme composé intermédiaire et comme composé du métal et du matériau semi-conducteur et de l'autre matériau semi-conducteur.
